# EUROPÄISCHE PATENTSCHRIFT

(11) **EP 0 811 238 B1**
(45) Veröffentlichungstag und Bekanntmachung des Hinweises auf die Patenterteilung: **22.08.2001**
(21) Anmeldenummer: 96900859.8
(22) Anmeldetag: 23.01.1996
(51) Int. Cl.: H01J 37/34

(54) **EINRICHTUNG ZUR REAKTIVEN BESCHICHTUNG**
REACTIVE SPUTTERING DEVICE
DISPOSITIF DE PULVERISATION REACTIVE

(30) Priorität: 24.02.1995 DE 19506513
(43) Veröffentlichungstag der Anmeldung: 10.12.1997
(73) Patentinhaber: FRAUNHOFER-GESELLSCHAFT ZUR FÖRDERUNG DER ANGEWANDTEN FORSCHUNG E.V., 80636 München (DE)
(72) Erfinder: FRACH, Peter, D-01324 Dresden (DE); WALDE, Hendrik, Fort Collins, CO 80526 (US); GOTTFRIED, Christian, D-01219 Dresden (DE); HOLFELD, Andreas, D-01187 Dresden (DE); GOEDICKE, Klaus, D-01307 Dresden (DE)
(86) Internationale Anmeldenummer: DE9600114
(87) Internationale Veröffentlichungsnummer: WO9626533

(56) Entgegenhaltungen:
- EP-A- 0 227 438
- DE-C- 4 127 262
- PATENT ABSTRACTS OF JAPAN vol. 014, no. 539 (C-0782), 28.November 1990 & JP,A,02 225663 (TOKUDA SEISAKUSHO LTD), 7.September 1990,
- PATENT ABSTRACTS OF JAPAN vol. 015, no. 211 (C-0836), 29.Mai 1991 & JP,A,03 061367 (SHIMADZU CORP), 18.März 1991,

## Beschreibung

Die Erfindung betrifft eine Einrichtung zur reaktiven Beschichtung von Substraten mittels einer Zerstäubungsquelle nach dem Magnetronprinzip. Die zu zerstäubenden Targets bestehen aus mehreren Teiltargets und sind meist konzentrisch umeinander angeordnet zu einer sogenannten Mehrringquelle. Das Target besteht aus einem elektrisch leitfähigen Material.

Beim reaktiven Beschichten wird ein in der Regel elektrisch leitfähiges Target (z. B. Al, Ti, In, C, Si) einer Zerstäubungsquelle zerstäubt. Die Führung des Entladungsplasmas in einem in sich geschlossenen, aus bogenförmig gekrümmten Magnetfeldlinien gebildeten magnetischen Tunnel vor dem Target erhöht die Plasmadichte und die Zerstäubungsrate wesentlich. Werden Reaktivgase, wie
z. B. O₂, N₂, H₂, CₓH_{y} in den Entladungsraum eingelassen, so kommt es zur Bildung von Verbindungen, wie z. B. Al₂O₃, SiO₂, TiN.
Die reaktive Magnetronentladung weist durch die Reaktivgaskomponente einen zusätzlichen Freiheitsgrad auf. Bei sehr vielen Target/Reaktivgaskombinationen treten zumindest in Teilen des Arbeitsbereiches Instabilitäten auf. Die Entladung springt in einen vollständig anderen Arbeitspunkt, der andere Beschichtungsparameter und andere Schichteigenschaften zur Folge hat. Dabei spielen u. a. Gasdruck, Reaktivgasfluß, Entladungsleistung und das Pumpensaugvermögen eine Rolle.

Zur Stabilisierung der reaktiven Magnetronentladung wurden bereits verschiedene Verfahren und Einrichtungen beschrieben. Eines der am geeignetsten erscheinenden Verfahren besteht darin, daß die Partialdrücke des Edelgases und Reaktivgases derart gewählt werden, daß der Entladungsstrom oder die Entladungsspannung bei Änderung des Reaktivgaspartialdruckes konstant bleibt und die Abhängigkeit des Entladungsstromes oder der Entladungsspannung vom Reaktivgaspartialdruck zur Regelung des Reaktivgases verwendet wird (DD 146 306).
Es ist weiterhin bekannt, in einem Regelverfahren die Entladung im physikalischen Arbeitspunkt Entladungsstrom bzw. Entladungsspannung beim zugehörigen Reaktivgasfluß durch Dosierung des eingeleiteten Reaktivgases einzustellen und konstant zu halten (DE 41 06 513 A1). Beide Verfahren eignen sich jedoch nur zur relativ kurzzeitigen Stabilisierung für einen Bruchteil der Targetstandzeit und für Zerstäubungsquellen mit nur einer in sich geschlossenen Plasmaentladung. Im Laufe der Gebrauchsdauer des Targets verändert sich mit der Erosionstiefe auch die wirksame Magnetfeldstärke und damit die Entladungsparameter und die Reaktionskinetik. Die Eigenschaften der abgeschiedenen Schichten ändern sich, und es muß eine ständige Nachführung des Arbeitspunktes anhand gemessener Schichteigenschaften erfolgen. Weiterhin kommt es durch die fokussierende Wirkung des Erosionsgrabens zur Ausbildung einer sich verbreiternden Rückstäubzone an den Targeträndern. Insbesondere bei isolierenden Schichten wie Al₂O₃ oder SiO₂ führen diese Rückstäubzonen zu Bogenentladungen und damit zu Partikeln in der abgeschiedenen Schicht.
Ein weiterer entscheidender Nachteil der gegenwärtig bekannten technischen Lösungen ist, daß sie es nicht erlauben, mit mehreren Teiltargets gleicher oder unterschiedlicher Teilleistung einen reaktiven Zerstäubungsprozeß langzeitstabil und reproduzierbar über eine Targetstandzeit zu realisieren. Ein Anwendungsbeispiel ist die reaktive Schichtabscheidung mittels Zweiringquelle zur Abscheidung von Schichten auf Substraten mit Durchmesser größer 100 mm mit einer sehr guten Homogenität der Schichtdicke und der Schichteigenschaften. Die Leistungsdichten und damit die Targeterosion auf den konzentrischen Teiltargets unterscheiden sich je nach Beschichtungsgeometrie etwa um den Faktor 2 bis 5 voneinander. Die Änderung der Plasmaparameter mit zunehmender Targeterosion ist deshalb sehr unterschiedlich.
Es ist bekannt, beim nichtreaktiven Beschichten durch Zerstäuben die Einstellung der Schichtdickengleichmäßigkeit durch Wahl der Teilentladungsleistungen vorzunehmen (DE 41 27 262 C1). Die reaktive Betriebsweise einer derartigen Zerstäubungsquelle stellt jedoch außerordentlich hohe Anforderungen an diese Einrichtung, um u. a. die Stöchiometriehomogenität langzeitstabil und reproduzierbar zu erzielen. Die Gründe dafür sollen im Folgenden kurz erläutert werden. Die Stabilität der Entladung, ihr Arbeitspunkt und damit die Stöchiometrie wird entscheidend vom Verhältnis Leistungsdichte zum Reaktivgasangebot bestimmt. Außerdem hängen einige Schichteigenschaften, z. B. die Härte, und die Beschichtungsrate außer von der Stöchiometrie auch von den eingestellten Werten der Entladungsspannung und/oder des Entladungsstromes ab [P. Frach et all, *Surface and Coating Technology*, 59(1993)177]. Wenn nur die Teilentladungsleistungen einstellbar sind, führt dies letztlich zu einer Drift der Schichteigenschaften und deren Homogenität. Z.B. führt eine kurzeitige lokale Schwankung an O₂ beim reaktiven Abscheiden von Al₂O₃ vom Al-Target zum Verschieben des Arbeitspunktes der Entladung des jeweiligen Teiltargets und damit zu Eigenschaftsveränderungen.
Eine weitere bekannte Einrichtung besteht aus zwei elektrisch getrennten Katoden und einer Anode. Die Katoden werden an eine Wechselspannung angeschlossen. Die Anode ist über eine zusätzliche Gleichspannungsquelle an den Symmetriepunkt der Wechselspannung angeschlossen (DE 40 42 287 A1). Bei dieser Anordnung ist das Magnetfeld unveränderbar. Im Verlaufe der Targeterosion nimmt die Magnetfeldstärke zu. Dies führt zu einer abnehmenden Plasmaimpedanz und zu steiler werdenden Strom-Spannungs-Kennlinien. Damit nimmt die ohnehin bei reaktiven Entladungen vorhandene Neigung zu Instabilitäten der Entladung und hochfrequenten Schwingungen stetig zu. Die Nutzungsdauer der Targets ist dadurch begrenzt. Ein weiterer Nachteil dieser Einrichtung ist die Unmöglichkeit der getrennten Leistungseinspeisung in beide Katoden. Die reaktiven Arbeitspunkte der beiden Entladungen lassen sich nicht getrennt einstellen. Werden Schichten abgeschieden, deren Sekundärelektronenausbeute kleiner ist als diejenige des Katodenmaterials (z.B. CrO), so führt eine leichte Differenz der Bedeckungsgrade beider Katoden mit dem Reaktionsprodukt zu einer positiven Rückkopplung und zu stetig abnehmender Leistungseinspeisung der einen Katode. Der Arbeitspunkt und damit Beschichtungsrate und Schichteigenschaften auf dem Substrat sind unterschiedlich. Für bestimmte Anwendungen ist es z. B. erforderlich, beide Katoden mit definiert und aufeinander abgestimmt unterschiedlicher Leistungsdichte zu betreiben. Auch dies ist mit der beschriebenen Einrichtung nicht möglich.

Der Erfindung liegt die Aufgabe zugrunde, eine Einrichtung zur reaktiven Beschichtung von Substraten nach dem Magnetronprinzip zu schaffen, mit der es möglich ist, Substrate mit Abmessungen >100 Ø mm mit hoher Gleichmäßigkeit sowohl der Schichtdicke als auch der Stöchiometrie zu beschichten. Die Leistungsdichte für die Teiltargets soll unabhängig voneinander wählbar sein. Es soll möglich sein, auch elektrisch schlecht leitende oder isolierende Schichten, wie Al₂O₃, SiO₂, CrO oder TiO₂ ohne störende Partikel in der Schicht abzuscheiden. Der Beschichtungsprozeß soll ohne oder mit stark verringerter Neigung der elektrischen Entladung zum Schwingen und dadurch mit deutlich verbesserter Stabilität durchführbar sein. Die Einrichtung soll es ermöglichen, diese Eigenschaften, wie Gleichmäßigkeit von Schichtdicke, Stöchiometrie und physikalischer Eigenschaften der abgeschiedenen Schicht, Partikelfreiheit und Entladungsstabilität, über die gesamte Targetnutzungsdauer zu erhalten.

Erfindungsgemäß wird die Aufgabe nach den Merkmalen des Patentanspruches 1 gelöst. Weitere vorteilhafte Ausgestaltungen sind in den Unteransprüchen 2 bis 7 beschrieben.

Die erfindungsgemäße Einrichtung hat den Vorteil, daß das magnetische Feld auf der dem Entladungsraum zugewandten Seite der Teiltargets relativ zueinander veränderbar ist. Durch die veränderbaren Magnetfelder, die galvanische Trennung der Teiltargets und den regelbaren Gaseinlaß kann jede Teilentladung in einem unabhängig voneinander gewählten reaktiven Arbeitspunkt stabilisiert werden. Damit ist es möglich, gegenüber dem Stand der Technik nicht nur eine gleichmäßige Schichtdicke, sondern auch gleichmäßige Stöchiometrie und physikalische Eigenschaften der abgeschiedenen Schicht über einen großen Substratbereich zu erhalten. Diese Gleichmäßigkeit läßt sich sogar bei deutlich unterschiedlichen Leistungsdichten für alle einzelnen Entladungen und unterschiedlichen Erosionsgeschwindigkeiten erreichen. Weiterhin werden die Teiltargets bis zum Rand auch im reaktiven Betrieb von Rückstäubzonen frei zerstäubt. Dies wird erreicht durch das im Zentrum innerhalb des innersten Teiltargets, zwischen je zwei aufeinanderfolgenden Teiltargets und außerhalb des äußersten Teiltargets angeordnete Zwischenstück, das elektrisch von den Teiltargets isoliert und auf beliebiges elektrisches Potential schaltbar ist. Durch Nachführung der Magnetstärke mit zunehmender Targeterosion ist es sogar möglich, diesen Zustand des rückstäubungsfreien Targets über die gesamte Targetnutzungsdauer einzustellen. Ein weiterer Vorteil der Magnetfeldanpassung besteht darin, daß die Entladung über die gesamte Targetnutzungsdauer mit gleicher Entladungscharakteristik (Strom-Spannungs-Kennlinie) betreibbar ist. Die bei fortschreitender Targeterosion ohne Magnetfeldanpassung steiler werdende Strom-Spannungs-Kennlinie und die damit verbundene Neigung zu hochfrequenten Schwingungen wird auf diese Weise verhindert bzw. stark reduziert.

Ein besonderer Vorteil der erfindungsgemäßen Einrichtung ist es, daß die Teiltargets sogar aus unterschiedlichen Materialien bestehen können. Dadurch können Mischverbindungen reaktiv zerstäubt hergestellt werden. Dies ist möglich durch die völlig freie Wahl der Arbeitspunkte beider Teilentladungen. Durch getrennte regelbare Gaseinlässe für jedes Teiltarget ist es sogar möglich unterschiedliche Regelcharakteristiken für die Teiltargets einzustellen. Dies ermöglicht das bisher nicht realisierbare Kombinieren von Materialien mit vollständig unterschiedlichem bzw. gegenläufigem Verhalten der Plasmaimpedanz bei Reaktivgaseinlaß.

An einem Ausführungsbeispiel wird die Erfindung näher erläutert. Die zugehörige Zeichnung zeigt einen Halbschnitt durch eine Zerstäubungsquelle nach dem Magnetronprinzip.

Der Rezipient ist durch einen Flansch 2 vakuumdicht abgeschlossen. Auf dem Flansch 2 sind auf Kühlplatten 3; 3' isoliert die Teiltargets 4, 4' konzentrisch angeordnet und bilden eine sogenannte Zweiringquelle. In den Teiltargets 4; 4' befinden sich Kühlwasserkanäle 5. Im Zentrum des inneren Teiltargets 4 und zwischen den Teiltargets 4 und 4' sowie um das Teiltarget 4' sind ringförmige Zwischenstücke 6; 6'; 6" konzentrisch, ebenfalls vom Flansch 2 isoliert angeordnet. In den Zwischenstücken 6 und 6" ist ein Kanal 7 eingebracht, in den das Reaktionsgas O₂ über die Leitungen 8 geleitet wird. Aus den über den Umfang verteilten Düsen 9 tritt dieses so aus, daß es sich über den Teiltargets 4, 4' verbreitet. Am äußeren Zwischenstück 6" ist der Plasmaschirm 10 angeordnet.
Um diesen Plasmaschirm 10 herum ist in gleicher Ebene mit dem Zwischenstück 6" eine ringförmige Zusatzelektrode 11 isoliert vom Flansch 2 angeordnet. In diesem ist ebenfalls ein Kanal 12 mit über den Umfang verteilten Düsen 13 angeordnet. Aus diesen Düsen 13 tritt das über die Leitung 14 zugeführte Inertgas Ar aus.
In bekannter Weise sind unter dem Flansch die Magneten 15; 15' in Richtung der Teiltargets 4; 4' bewegbar unter diesen derart angeordnet, daß sich tunnelförmige Magnetfelder über den Teiltargets 4; 4' bilden.
Der Zerstäubungsprozeß wird aufrechterhalten und geregelt, indem den Teiltargets 4; 4' von der Stromversorgungseinrichtung 16 je nach Betriebsart Gleich- oder Wechselstrom zugeführt wird. Eine Meß- und Regeleinrichtung 17 steuert den Fluß des Reaktionsgases O₂ über Regelventile 18; 18'. Das Reaktionsgas O₂ wird aus einem Speicher 19 bereitgestellt.
Die Teiltargets 4; 4' sind elektrisch mit den negativen Polen einer gepulsten Stromversorgungseinrichtung 16 verbunden und die Zusatzelektrode 11 ist mit dem positiven Pol verbunden. Die Meß- und Regeleinrichtung 17 ist derart angeschlossen, daß die elektrischen Meßgrößen der Plasmaentladung (Strom, Spannung, Leistung) erfaßt und daraus Stellsignale für die Regelventile 18; 18' abgeleitet werden.
Über dem Entladungsraum ist das zu beschichtende Substrat 20 angeordnet.
Das Magnetfeld kann sowohl mit Permanentmagneten als auch mit Elektromagneten, oder einer Kombination beider erzeugt werden.

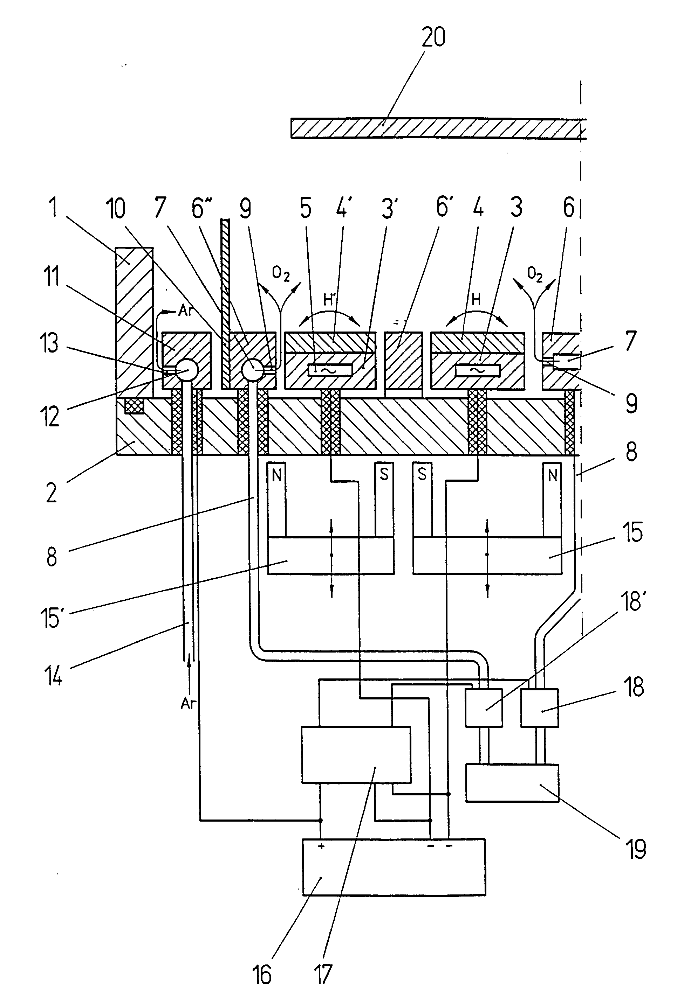

## Patentansprüche

1. Einrichtung zur reaktiven Beschichtung von Substraten, bestehend aus einer Zerstäubungsquelle nach dem Magnetronprinzip, deren Target aus mindestens zwei galvanisch voneinander getrennten Teiltargets besteht, die auf einer jedem Target bzw. Teiltarget zugeordneten, galvanisch voneinander getrennten Kühlplatte angeordnet sind, hinter den Teiltargets bzw. deren Kühlplatte ist ein Magnetsystem aus mehreren Magneten zur Erzeugung des magnetischen Tunnels für jedes Teiltarget angeordnet, wobei der Zerstäubungsquelle mindestens eine unipolare oder bipolare Leistungseinspeisungs-Einrichtung zur gepulsten Zuführung der Energie zugeordnet ist, **dadurch gekennzeichnet,** daß zwischen den konzentrisch angeordneten Teiltargets (4; 4') im Zentrum des innersten Teiltargets (4) und um das äußerste Teiltaget (4') von den Teiltargets (4; 4') isoliert und auf beliebiges elektrisches Potential schaltbar je ein Zwischenstück (6; 6'; 6") in Fortsetzung der hinter den Teiltargets (4; 4') befindlichen Magnetpole angeordnet ist, daß mindestens einem Teiltarget (4; 4') ein regelbarer Gaseinlaß für Reaktivgas und/oder Reaktivgas-Inertgas-Gemisch zugeordnet ist, und daß das Magnetsystem derart ausgebildet ist, daß die Magnetfeldstärke mindestens eines, einen magnetischen Tunnel bildenden Magnetfeldes relativ zur Magnetfeldstärke eines weiteren, einen magnetischen Tunnel (H; H') bildenden Magnetfeldes veränderbar ist.

2. Einrichtung nach Anspruch 1, **dadurch gekennzeichnet,** daß die Zwischenstücke (6; 6'; 6") teilweise oder vollständig aus weichmagnetischem Material bestehen.

3. Einrichtung nach Anspruch 1 und 2, **dadurch gekennzeichnet,** daß zwischen jedem Zwischenstück (6; 6'; 6") und Teiltarget (4; 4') ein Spalt zum Austritt des Reaktivgases und/oder Reaktivgas-Inertgas-Gemisches in Targetnähe angeordnet ist.

4. Einrichtung nach Anspruch 1 bis 3, **dadurch gekennzeichnet,** daß in jedem Zwischenstück (6; 6') eine Leitung (7) für Reaktivgas und/oder Reaktivgas-Inertgas-Gemisch angeordnet ist und diese mit Öffnungen (9) zur Leitung besagten Gases in die Spalte zwischen den Zwischenstücken (6; 6') und Teiltargets (4; 4') versehen ist.

5. Einrichtung nach Anspruch 1 bis 4, **dadurch gekennzeichnet,** daß die Teiltargets (4; 4') mit den Ausgängen der bipolaren Leistungseinspeisungs-Einrichtung (16) verbunden sind, mittels derer die Teiltargets (4; 4') abwechselnd als Katode und Anode geschaltet sind und daß um das äußere Teiltarget (4') eine Zusatzelektrode (11) angeordnet und elektrisch unbeschaltet ist.

6. Einrichtung nach Anspruch 1 bis 4, **dadurch gekennzeichnet,** daß die Teiltargets (4; 4') mit je einem Ausgang einer unipolaren Leistungseinspeisungs-Einrichtung (16) verbunden sind, deren anderer Ausgang mit einer das äußere Teiltarget (4') umgebenden Zusatzelektrode (11) verbunden ist, die isoliert gegen die Teiltargets (4; 4') ist.

7. Einrichtung nach Anspruch 5 und 6, **dadurch gekennzeichnet,** daß die Zusatzelektrode (11) Bestandteil des Rezipienten (1) ist.

## Claims

1. Device for reactive coating of substrates, comprising a sputtering source according to the magnetron principle, the target of which device comprises at least two partial targets which are separated from each other galvanically and are disposed on a cool plate which is assigned to each target or partial target and is separated from the other galvanically; behind the partial targets or their cool plate is a magnetic system which comprises a plurality of magnets for producing the magnetic tunnel for each partial target, at least one unipolar or bipolar power supply device being assigned to the sputtering source for pulsed supply of energy, **characterised in that** between each of the concentrically disposed partial targets (4; 4') there is disposed an intermediate piece (6; 6'; 6") in the centre of the innermost partial target (4) and around the outermost partial target (4'), which intermediate piece is insulated from the partial targets (4) and connectable to any electrical potential, said intermediate piece being disposed as an extension of the magnetic poles located behind the partial targets (4; 4'), in that an adjustable gas inlet for reactive gas and/or a reactive gas/inert gas mixture is assigned to at least one partial target (4; 4'), and in that the magnetic system is configured in such a manner that the magnetic field strength of at least one magnetic field forming a magnetic tunnel is variable relative to the magnetic field strength of a further magnetic field forming a magnetic tunnel (H; H').

2. Device according to claim 1, **characterised in that** the intermediate pieces (6; 6'; 6") are made in part or entirely of soft magnetic material.

3. Device according to claim 1 and 2, **characterised in that** a gap for output of the reactive gas and/or the reactive gas/inert gas mixture is disposed close to the target between each intermediate piece (6; 6'; 6") and partial target (4; 4').

4. Device according to claim 1 to 3 **characterised in that** a pipe (7) for reactive gas and/or the reactive gas/inert gas mixture is disposed in each intermediate piece (6; 6') and this pipe (7) is provided with openings (9) for conducting said gas into the gaps between the intermediate pieces (6; 6') and the partial targets (4; 4').

5. Device according to claim 1 to 4, **characterised in that** the partial targets (4; 4') are connected to the outputs of the bipolar power supply device (16), by means of which the partial targets (4; 4') are connected alternately as cathode and anode and in that an ancillary electrode (11) is disposed around the outer partial target (4') and is electrically disconnected.

6. Device according to claim 1 to 4, **characterised in that** the partial targets (4; 4') are each connected to an output of a unipolar power supply device (16), the other output of which is connected to an ancillary electrode (11) which surrounds the outer partial target (4') and is insulated from the partial targets (4; 4').

7. Device according to claim 5 and 6, **characterised in that** the ancillary electrode (11) is a component of the container (1).

## Revendications

1. Installation de dépôt réactif en couche de substances, comportant une source de pulvérisation fonctionnant selon le principe du magnétron et possédant une cible composée de deux cibles partielles électriquement séparées, montées chacune sur une plaque de refroidissement électriquement séparée de l'autre plaque, tandis que derrière la cible partielle et sa plaque de refroidissement est monté un système magnétique composé de plusieurs aimants pour réaliser le tunnel magnétique de chaque cible partielle, au moins une installation de puissance unipolaire ou bipolaire étant associée à la source de pulvérisation comme fournisseur d'énergie pulsée,
caractérisée en ce qu'
- entre les cibles partielles (4, 4') disposées concentriquement, au centre de la cible partielle interne (4) et autour de la cible partielle externe (4') sont montées, isolées des cibles partielles (4, 4') et pouvant être portées à un potentiel électrique choisi à volonté, des pièces intermédiaires (6, 6', 6") en prolongement des pôles magnétiques situés derrière les cibles partielles (4, 4'),
- à au moins une cible partielle (4, 4') est associée une amenée réglable d'un gaz réactif ou d'un mélange gaz réactif/gaz inerte, et
- le système magnétique est constitué de manière que la force d'au moins un champ magnétique formant un tunnel magnétique peut être modifiée par rapport à la force d'un autre champ magnétique formant un tunnel magnétique (H, H').

2. Installation selon la revendication 1,
caractérisée en ce que
les pièces intermédiaires (6, 6', 6") sont faites, en tout ou en partie, d'un matériau magnétique doux.

3. Installation selon la revendication 1 ou 2,
caractérisée en ce qu'
entre chaque pièce intermédiaire (6, 6', 6") et une cible partielle (4, 4') existe une fente de sortie du gaz réactif et/ou du mélange de gaz réactif/gaz inerte, près de la cible.

4. Installation selon l'une quelconque des revendications 1 à 3,
caractérisée en ce que
dans chaque pièce intermédiaire (6, 6') se trouve une canalisation (7) de gaz réactif et/ou de mélange gaz réactif/gaz inerte, et cette canalisation est munie d'ouvertures (9) amenant le gaz indiqué dans la fente entre la pièce intermédiaire (6, 6') et la cible partielle (4, 4').

5. Installation selon l'une quelconque des revendications 1 à 4,
caractérisée en ce que
la cible partielle (4, 4') est reliée aux sorties de l'installation bipolaire d'alimentation de puissance (16), par l'intermédiaire de laquelle la cible partielle (4, 4') est alimentée alternativement comme cathode ou comme anode, une électrode auxiliaire (11) étant montée autour de la cible partielle externe (4') sans être connectée électriquement.

6. Installation selon l'une quelconque des revendications 1 à 4,
caractérisée en ce que
les cibles partielles (4, 4') sont reliées chacune à une sortie d'une installation unipolaire d'alimentation de puissance (16) dont l'autre sortie est reliée à une électrode auxiliaire (11) entourant la cible partielle externe (4') et isolée des cibles partielles (4, 4').

7. Installation selon l'une quelconque des revendications 5 ou 6,
caractérisée en ce que
l'électrode auxiliaire (11) est un composant du récipient (1).
